# EUROPÄISCHE PATENTSCHRIFT

(11) **EP 0 944 915 B1**
(45) Veröffentlichungstag und Bekanntmachung des Hinweises auf die Patenterteilung: **07.11.2001**
(21) Anmeldenummer: 97932735.0
(22) Anmeldetag: 03.07.1997
(51) Int. Cl.: H01L 21/033, H01L 21/3205, H01L 21/308, H01L 21/311

(54) **VERFAHREN ZUR HERSTELLUNG EINES KONDENSATORS IN EINER HALBLEITERANORDNUNG**
PROCESS FOR MANUFACTURING A CAPACITOR IN A SEMICONDUCTOR ARRANGEMENT
PROCEDE DE FABRICATION D'UN CONDENSATEUR POUR UN DISPOSITIF A SEMI-CONDUCTEUR

(30) Priorität: 14.08.1996 DE 19632835
(43) Veröffentlichungstag der Anmeldung: 29.09.1999
(73) Patentinhaber: Infineon Technologies AG, 81669 München (DE)
(72) Erfinder: SCHÄFER, Herbert, D-85635 Höhenkirchen-Siegertsbrunn (DE); FRANOSCH, Martin, D-81739 München (DE); STENGL, Reinhard, D-86391 Stadtbergen (DE); LEHMANN, Volker, D-80689 München (DE); REISINGER, Hans, D-82031 Grünwald (DE); WENDT, Hermann, D-85630 Grasbrunn (DE)
(74) Vertreter: Zedlitz, Peter, Dipl.-Inf.
(86) Internationale Anmeldenummer: DE9701408
(87) Internationale Veröffentlichungsnummer: WO9807184

(56) Entgegenhaltungen:
- EP-A- 0 567 748
- US-A- 5 158 905
- US-A- 5 254 503
- US-A- 5 346 846
- MINE T ET AL: "CAPACITANCE-ENHANCED STACKED-CAPACITOR WITH ENGRAVED STORAGE ELECTRODE FOR DEEP SUBMICRON DRAMS" JAPANESE JOURNAL OF APPLIED PHYSICS, SUPPLEMENTS, 28.August 1989, Seiten 137-140, XP000607864

## Beschreibung

In verschiedenen integrierten Schaltungen, wie z. B. dynamische Speicherzellenanordnungen, Analog-Digital- und Digital-Analog-Wandler sowie Filterschaltungen, werden Kondensatoren auf Halbleiterbasis eingesetzt. Bei der Herstellung von Kondensatoren auf Halbleiterbasis ist im Hinblick auf eine erhöhte Integrationsdichte oder reduzierte Chipfläche das Problem zu lösen, den Platzbedarf des Kondensators bei gleichbleibender Kapazität zu reduzieren.

Dieses Problem ist besonders gravierend bei dynamischen Halbleiterspeichern, bei denen die benötigte Fläche der im allgemeinen verwendeten Eintransistorspeicherzelle von Speichergeneration zu Speichergeneration mit zunehmender Speicherdichte reduziert wird. Gleichzeitig muß eine gewisse Mindestkapazität des Speicherkondensators erhalten bleiben.

Eine Eintransistorspeicherzelle einer dynamischen Halbleiterspeicheranordnung (DRAM-Speicheranordnung) umfaßt einen Auslesetransistor und einen Kondensator. In dem Kondensator ist die Information in Form einer elektrischen Ladung gespeichert, die eine logische Größe, 0 oder 1, darstellt. Durch Ansteuerung des Auslesetransistors über eine Wortleitung kann diese Information über eine Bitleitung ausgelesen werden. Zur sicheren Speicherung der Ladung und gleichzeitigen Unterscheidbarkeit der ausgelesenen Information muß der Kondensator eine Mindestkapazität aufweisen. Die untere Grenze für die Kapazität des Speicherkondensators wird derzeit bei 25 fF gesehen.

Bis zur 1 MBit-Generation wurden sowohl der Auslesetransistor als auch der Kondensator als planare Bauelemente realisiert. Ab der 4 MBit-Speichergeneration wurde eine weitere Flächenreduzierung der Speicherzelle durch eine dreidimensionale Anordnung von Auslesetransistor und Speicherkondensator erzielt. Eine Möglichkeit dafür besteht darin, den Speicherkondensator in einem Graben zu realisieren (s. z. B. K. Yamada et al, Proc. Intern. Electronic Devices and Material, IEDM 85, S. 702 ff.). Die Elektroden des Speicherkondensators sind in diesem Fall entlang der Oberfläche des Grabens angeordnet. Dadurch wird die effektive Fläche des Speicherkondensators, von der die Kapazität abhängt, gegenüber dem Platzbedarf an der Oberfläche des Substrats für den Speicherkondensator, der dem Querschnitt des Grabens entspricht, vergrößert.

Eine weitere Möglichkeit, zur Vergrößerung der Speicherkapazität bei gleichbleibendem oder verringertem Platzbedarf des Speicherkondensators besteht darin, den Speicherkondensator als Stapelkondensator, den sogenannten "stacked capacitor", auszuführen. Dabei wird über den Wortleitungen eine Struktur aus Polysilizium, z. B. eine Kronenstruktur oder ein Zylinder gebildet, die mit dem Substrat kontaktiert wird. Diese Polysiliziumstruktur bildet den Speicherknoten. Er wird mit Kondensatordielektrikum und Kondensatorplatte versehen. Dieses Konzept hat den Vorzug, daß es weitgehend mit einem Logikprozeß kompatibel ist. Für den Speicherkondensator wird der freie Raum oberhalb der Substratoberfläche genutzt. Dabei kann die gesamte Zellfläche von der Polysiliziumstruktur überdeckt sein, so lang die Polysiliziumstrukturen zu benachbarten Speicherzellen gegeneinander isoliert sind.

Aus EP 0 415 530 B1 ist eine Speicherzellenanordnung mit einem Stapelkondensator als Speicherkondensator bekannt. Der Stapelkondensator umfaßt eine Polysiliziumstruktur mit mehreren, im wesentlichen parallel übereinander angeordneten Polysiliziumschichten, die über mindestens eine seitliche Stütze miteinander verbunden sind. Diese kühlrippenartig angeordneten Schichten führen zu einer deutlichen Vergrößerung der Oberfläche der Polysiliziumstruktur gegenüber der Projektion der Polysiliziumstruktur auf die Substratoberfläche. Die Polysiliziumstruktur wird durch alternierende Abscheidung von Polysiliziumschichten und selektiv dazu ätzbaren SiO₂-Schichten auf der Oberfläche des Substrats, Strukturierung dieser Schichten, Bildung der seitlichen Stütze und selektives Herausätzen der SiO₂-Schichten gebildet. Die Polysiliziumstrukturen sind dabei arsendotiert. Anschließend wird durch thermische Oxidation Siliziumoxid als Kondensatordielektrikum gebildet, auf dem eine Zellplatte aus dotiertem Polysilizium abgeschieden wird. Die erforderliche mechanische Stabilität der parallel angeordneten Polysiliziumschichten und die Tatsache zwischen parallel angeordneten Polysiliziumschichten das Kondensatordielektrikum und die Zellplatte einbringen zu müssen, begrenzt die mögliche Oberflächenvergrößerung.

In US 5 254 503 ist vorgeschlagen worden zur Oberflächenvergrößerung einer Kondensatorelektrode, diese mit Hilfe einer Maske aus Polysiliziumkeimen, die durch CVD-Abscheidung gebildet werden, oder mit Hilfe einer Maske, die unter Ausnutzung von Oberflächenrauhigkeiten gebildet wurde, zu strukturieren. Die Strukturen in der Maske sind in Größe und Dichte statistisch, so daß die Oberflächenvergrößerung und damit die erzielbare Kapazität schlecht kontrollierbar ist.

Der Erfindung liegt das Problem zugrunde, ein Verfahren zur Herstellung eines Kondensators in einer Halbleiteranordnung, insbesondere für eine DRAM-Anordnung, anzugeben, mit dem eine Erhöhung der Packungsdichte erzielt wird und bei dem die Kapazität des Kondensators kontrollierbar ist.

Dieses Problem wird erfindungsgemäß gelöst durch ein Verfahren gemäß Anspruch 1. Weitere Ausgestaltungen der Erfindung gehen aus den übrigen Ansprüchen hervor.

Zur Herstellung des Kondensators wird auf einem Substrat eine statistische Maske mit statistisch verteilten Maskenstrukturen gebildet. Die statistisch verteilten Maskenstrukturen werden ohne Einsatz von lithographischen Verfahren durch Bildung von Keimen aus Silizium und/oder Germanium und anschließende selektive Epitaxie erzeugt. Dabei wird die Keimbildung unterbrochen, sobald eine vorgegebene Dichte der Keime erreicht ist. Die Größe der Keime wird anschließend durch selektive Epitaxie von Silizium eingestellt. Daher sind die statistisch verteilten Maskenstrukturen mit geringeren Strukturgrößen, als es der Auflösungsgrenze der Lithographie entspricht, herstellbar und sind dennoch in Größe und Dichte kontrollierbar.

In der Oberfläche des Substrats werden durch anisotropes Ätzen Säulenstrukturen gebildet, deren Querschnitt und Verteilung durch die Anordnung der statistisch verteilten Maskenstrukturen festgelegt wird. Die statistische Maske wird dabei als Ätzmaske verwendet. Am Säulenboden sind die Säulenstrukturen über ein Verbindungselement miteinander verbunden. Als Verbindungselement fungiert das an die Säulenstrukturen angrenzende Material. Werden die Säulenstrukturen in einer Schicht aus z. B. dotiertem Polysilizium gebildet, so wird diese Schicht nicht ganz durchgeätzt und der verbleibende, durchgehende Rest der Schicht bildet das Verbindungselement.

Mindestens die Oberfläche der Säulenstrukturen und des Verbindungselementes sind elektrisch leitend. Die Säulenstrukturen mit dem Verbindungselement bilden den Speicherknoten des Kondensators. Zur Fertigstellung des Kondensators wird eine dielektrische Schicht mit im wesentlichen konformer Kantenbedeckung erzeugt, die mindestens die Oberfläche der Säulenstrukturen bedeckt und die ein Kondensatordielektrikum bildet. Schließlich wird als Kondensatorplatte eine leitfähige Schicht mit im wesentlichen konformer Kantenbedeckung abgeschieden.

Vorzugsweise wird die statistische Maske mit Strukturgrößen im Bereich zwischen 1 und 100 nm gebildet. Das heißt, die Strukturgrößen der statistisch verteilten Maskenstrukturen liegen im Bereich zwischen 1 und 100 nm und die Abstände zwischen benachbarten statistisch verteilten Maskenstrukturen liegen ebenfalls in diesem Größenbereich. Die statistisch verteilten Maskenstrukturen können dabei sowohl als Einzelstrukturen als auch als zusammenhängende Wabenstrukturen ausgebildet werden. Damit werden Packungsdichten im Bereich zwischen 10⁸ und 10¹³ pro cm² erreicht. Diese Packungsdichte entspricht der Packungsdichte der Säulenstrukturen, die gemeinsam mit dem Verbindungselement den Speicherknoten bilden. Die Säulenstrukturen bewirken eine drastische Vergrößerung der Oberfläche des Speicherknotens.

Für die Flächenvergrößerung des Speicherknotens ist ferner das Aspektverhältnis der Säulenstrukturen bestimmend.

Unter Zugrundelegung einer Technologie mit einer minimal herstellbaren Strukturgröße von F = 0,25 µm, einer Speicherzelle mit einem Platzbedarf von 8 F² (F minimale Strukturgröße), einem Säulendurchmesser von 20 nm und einem mittleren Säulenabstand von 20 nm ergibt sich bei einem Aspektverhältnis von 20 eine Säulenhöhe von 400 nm und eine Kapazität von 25 fF bei Verwendung eines Kondensatordielektrikums aus einer Dreifachschicht aus Siliziumoxid, Siliziumnitrid und Siliziumoxid. Für ein 1 Gbit-DRAM ist ein Aspektverhältnis von 45 erforderlich, um eine Kapazität von 25 fF zu erzielen. Höhere Kapazitäten können in diesem Verfahren durch Einsatz von Materialien mit hoher relativer Dielektrizitätskonstante, insbesondere größer 100, erzielt werden.

Zur Bildung der statistischen Maske ist es vorteilhaft, an der Oberfläche des Substrats mit Hilfe eines CVD-Verfahrens Keime zu bilden. Dabei wird ausgenutzt, daß bei CVD-Verfahren durch die Einstellung der Prozeßparameter die Keimbildung beeinflußt werden kann. Zur Bildung der statistischen Maske werden die Parameter in dem CVD-Verfahren so eingestellt, daß die Keimbildung stark verlangsamt ist, so daß sich zunächst einzelne isolierte Keime bilden.

Vorzugsweise werden die Keime durch eine CVD-Abscheidung gebildet, bei der ein Prozeßgas verwendet wird, das mindestens eine der Verbindungen SiH₄, GeH4 und H₂ enthält.

Es wurde festgestellt, daß durch Verwendung eines Prozeßgases mit GeH4 in einem Trägergas, z. B. H₂, bei Drücken im Bereich von 1 bis 100 hPa und Temperaturen im Bereich von 500-700°C isolierte Germaniumkeime gebildet werden mit Strukturgrößen im Bereich von 10 bis 100 nm.

Es ist besonders vorteilhaft, die Keime unter Verwendung eines SiH₄, GeH₄ und H₂ enthaltenden Prozeßgases durch CVD-Abscheidung zu bilden. Dabei wird die Erkenntnis ausgenutzt, daß die Zugabe von GeH₄ bei einer CVD-Abscheidung unter Verwendung eines Prozeßgases, das hauptsächlich SiH₄ in einem Trägergas, z. B. H₂, enthält, die Keimbildung von Siliziumkeimen verzögert. Über die Zugabe von GeH₄ kann daher die Keimdichte eingestellt werden.

Im Hinblick auf hohe Selektivitäten der Ätzung bei der Bildung der Säulenstrukturen ist es vorteilhaft, in dem Substrat eine Maskenschicht vorzusehen, die unter Verwendung der statistischen Maske als Ätzmaske strukturiert wird und die anschließend gemeinsam mit der statistischen Maske bei der Bildung der Säulenstrukturen als Ätzmaske wirkt. Die Maskenschicht wird vorzugsweise aus einem Material gebildet, das für eine Hartmaske geeignet ist. Hierzu zählen z. B. TEOS-SiO₂ oder Si₃N₄.

Als Substrat ist z. B. ein Halbleitersubstrat, vorzugsweise aus monokristallinem Silizium oder ein SOI-Substrat geeignet.

Das Verfahren zur Herstellung des Kondensators ist besonders vorteilhaft einsetzbar bei der Herstellung eines Speicherkondensators einer DRAM-Anordnung. Dabei kann der Kondensator sowohl als Grabenkondensator im Substrat als auch als Stapelkondensator ausgebildet werden. In Bezug auf die Flächenvergrößerung ist die Herstellung des Kondensators als Stapelkondensator vorteilhaft. In diesem Fall umfaßt das Substrat ein Halbleitersubstrat mit Auswahltransistoren, Bitleitungen, Wortleitungen, einer isolierenden Schicht, die die Auswahltransistoren, die Bitleitungen und die Wortleitungen abdeckt und die vorzugsweise planarisiert ist, und einer leitenden Schicht, vorzugsweise aus dotiertem Polysilizium, in der nach dem erfindungsgemäßen Verfahren die Speicherknoten, die jeweils aus Säulenstrukturen und Verbindungselement zusammengesetzt sind, gebildet werden. Die isolierende Schicht umfaßt darüber hinaus Kontakte zwischen den herzustellenden Speicherknoten und Sourcegebieten der Auswahltransistoren.

Im folgenden wird die Erfindung anhand von Ausführungsbeispielen, die in den Figuren dargestellt sind, näher erläutert. Die Darstellung in den Figuren sind nicht maßstäblich.
- Figur 1: zeigt ein Substrat mit Auslesetransistoren, Wortleitungen, Bitleitungen, einer dotierten Polysiliziumschicht, einer Maskenschicht und statistisch verteilten Maskenstrukturen.
- Figur 2: zeigt das Substrat nach Strukturierung der Maskenschicht.
- Figur 3: zeigt das Substrat nach Bildung von Säulenstrukturen in der dotierten Polysiliziumschicht.
- Figur 4: zeigt das Substrat nach der Bildung einzelner Speicherknoten.
- Figur 5: zeigt das Substrat nach Fertigstellung von Speicherkondensatoren durch Erzeugung eines Kondensatordielektrikums und einer Kondensatorplatte.

Ein Substrat S umfaßt eine Scheibe aus monokristallinem Silizium 1, in der Auswahltransistoren mit jeweils Source-Drain-Gebieten 2, Gateoxid und als Wortleitungen 3 ausgebildeten Gate-Elektroden vorgesehen sind. Die Auswahltransistoren sind jeweils paarweise angeordnet, wobei zu einem Paar gehörige Auswahltransistoren ein gemeinsames Source-Drain-Gebiet 2 umfassen, das über einen Bitleitungskontakt 4 mit einer Bitleitung 5 verbunden ist. In der Siliziumscheibe 1 sind benachbarte Auswahltransistorpaare durch Isolationsstrukturen 6 gegeneinander isoliert. Als Isolationsstruktur 6 werden z. B. LOCOS-Isolationen oder Isolationsgräben (shallow-trench-isolation) verwendet.

Das Substrat S umfaßt ferner eine isolierende Schicht 7 mit planarer Oberfläche, die die Auswahltransistoren, die Wortleitungen 3 und die Bitleitungen 5 vollständig abdeckt. In der isolierenden Schicht 7 sind Speicherknotenkontakte 8 vorgesehen, die jeweils auf diejenigen Source-Drain-Gebiete 2 reichen, die nicht mit einem Bitleitungskontakt 4 versehen sind.

Ferner umfaßt das Substrat S eine dotierte Polysiliziumschicht 9, die an der Oberfläche der isolierenden Schicht 7 angeordnet ist. Die dotierte Polysiliziumschicht 9 weist eine Dicke von z. B. 500 nm auf. Sie ist z. B. n-dotiert mit einer Dotierstoffkonzentration von 10²¹/cm³. Sie wird z. B. durch in situ dotierte Abscheidung in einem CVD-Verfahren oder durch undotierte Abscheidung und anschließende Dotierung durch Implantation, Belegung oder Diffusion gebildet. Die Oberfläche der dotierten Polysiliziumschicht 9 bildet die Oberfläche des Substrat S.

Auf die Oberfläche der dotierten Polysiliziumschicht 9 wird eine Maskenschicht 10 aus z. B. SiO₂ in einer Schichtdicke von z. B. 20 nm aufgebracht. Für die Maskenschicht 10 kommen alle Materialien in Frage, die als Ätzmaske zur Strukturierung der dotierten Polysiliziumschicht 9 geeignet sind.

Auf der Oberfläche der Maskenschicht 10 werden statistisch verteilte Maskenstrukturen in Form von Keimen während einer Gasphasenabscheidung in einer Epitaxieanlage gebildet. Als Prozeßgas wird eine Atmosphäre aus H₂ und SiH₄ verwendet, wobei H₂ das Trägergas bildet. Ferner umfaßt die Atmosphäre GeH₄, das zur Verzögerung des Keimbildungsprozesses zugegeben wird. Der Partialdruck von SiH₄ und GeH₄ liegt im Bereich von 10⁻³ bis 1 hPa, der Partialdruck von H₂ liegt im Bereich von 1 bis 100 hPa. Die Abscheidung wird im Temperaturbereich zwischen 500°C und 700°C durchgeführt. Bei diesen Prozeßbedingungen bilden sich an der Oberfläche der Maskenschicht 10 einzelne Silizium/Germaniumkeime, die die Verteilung und Dichte der statistisch verteilten Maskenstrukturen bestimmen. Sobald die Dichte der Silizium/Germaniumkeime eine vorgegebene Dichte von etwa 5 x 10¹⁰/cm² erreicht hat, wird der Keimbildungsprozeß abgebrochen.

Anschließend werden die Prozeßbedingungen verändert, um die Größe der Silizium/Germaniumkeime gezielt einzustellen. Dazu werden Prozeßbedingungen eingestellt, wie sie für die selektive Epitaxie benutzt werden. Bei diesen Prozeßbedingungen ist eine weitere Keimbildung an der Oberfläche der Maskenschicht 10 unterbunden. Die selektive Epitaxie erfolgt z. B. mit einer Gasmischung aus H₂ und SiH₂Cl₂ im Temperaturbereich zwischen 600°C und 800°C. Dieser Gasmischung kann darüber hinaus GeH₄ zugegeben werden, um die Materialzusammensetzung der Keime und damit Materialeigenschaften wie z. B. Ätzselektivitäten und ähnliches einzustellen.

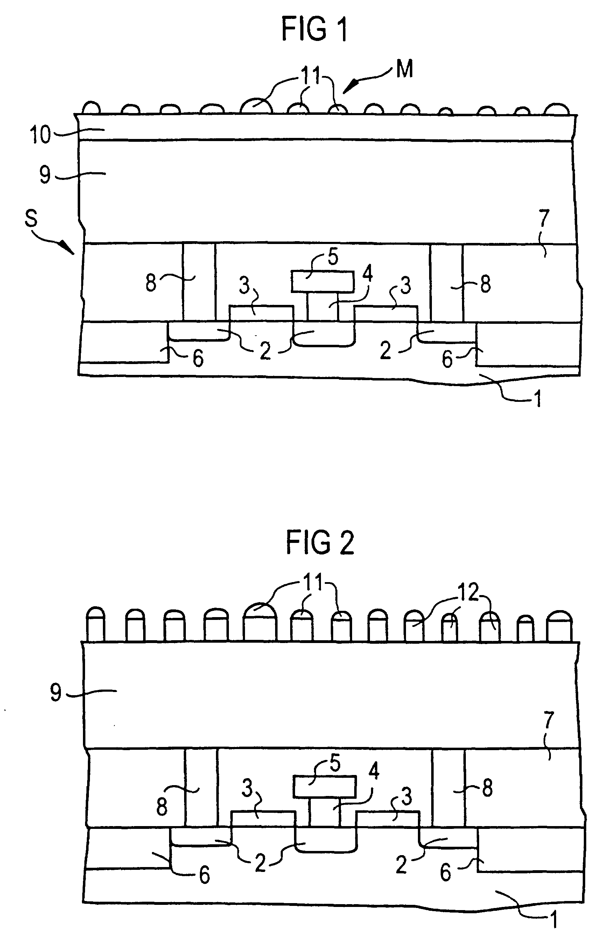

Sobald der Durchmesser der Keime einem vorgegebenen Wert entspricht, wird der Abscheideprozeß abgebrochen. Die Keime bilden die statistisch verteilten Maskenstrukturen 11, die zusammen eine statistische Maske M bilden (siehe Figur 1).

In einem anisotropen Ätzprozeß, der die Maskenschicht 10 selektiv zu den statistisch verteilten Maskenstrukturen 11 angreift, wird die Maskenschicht 10 strukturiert. Aus der Maskenschicht 10 wird dabei eine Hartmaske 12 gebildet (s. Figur 2). Die anisotrope Ätzung wird z. B. mit CHF₃/CF₄ durchgeführt.

Anschließend wird ein anisotroper Ätzprozeß durchgeführt, der Silizium selektiv zu SiO₂ angreift. Dabei werden in der dotierten Polysiliziumschicht 9 Säulenstrukturen 91 gebildet. Gleichzeitig werden die statistisch verteilten Maskenstrukturen 11, die aus Silizium oder Siliziumgermanium bestehen, entfernt. Der anisotrope Ätzprozeß wird z. B. mit HBr durchgeführt.

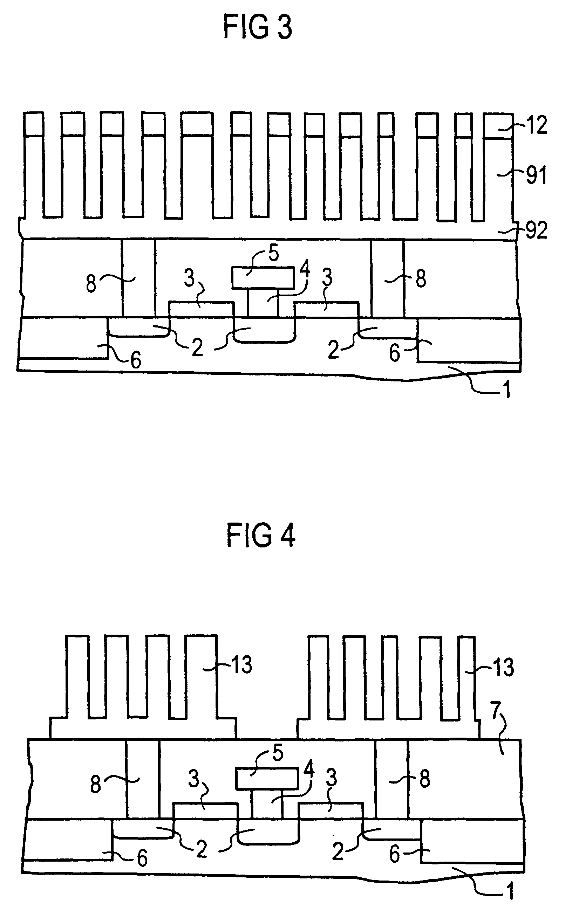

Die Säulenstrukturen 91 weisen eine Höhe auf, die geringer ist, als es der Dicke der dotierten Polysiliziumschicht 9 entspricht (s. Figur 3). Der verbleibende, durchgehende Rest der dotierten Polysiliziumschicht 9 bildet ein Verbindungselement 92, über das die Säulenstrukturen 91 miteinander verbunden sind. Die Säulenstrukturen 91 weisen eine Höhe von z. B. 400 nm auf.

Die Dichte, der Querschnitt und die Anordnung der Säulenstrukturen 91 sind durch die Anordnung der statistisch verteilten Maskenstrukturen 11 in der statistischen Maske M vorgegeben. Bei einem Säulendurchmesser von 20 nm, einer Säulenhöhe von 400 nm, einem mittleren Säulenabstand von 20 nm ergibt sich dadurch eine Flächenvergrößerung um den Faktor 16.

In einem isotropen Ätzprozeß, z. B. in einem HF-Dip, wird die Hartmaske 12 selektiv zu Silizium entfernt. Anschließend wird mit Hilfe fotolithographischer Verfahren ein anisotroper Ätzprozeß durchgeführt, bei dem in den Säulenstrukturen 91 und dem Verbindungselement 92 Gräben erzeugt werden, die jeweils bis auf die Oberfläche der isolierenden Schicht 7 reichen und die zu jedem Auswahltransistor einen Speicherknoten 13 definieren. Der Speicherknoten 13 ist jeweils gegenüber dem benachbarten Speicherknoten 13 isoliert und über den Speicherknotenkontakt 8 mit dem zugehörigen Source-Drain-Gebiet 2 elektrisch verbunden (s. Figur 4). Der anisotrope Ätzprozeß wird z. B. mit HBr durchgeführt.

Der Lithographieschritt und der anisotrope Ätzprozeß zur Trennung der einzelnen Speicherknoten 13 kann auch vor Bildung der Säulenstrukturen 91 erfolgen.

Anschließend wird die Oberfläche der Speicherknoten 13 mit einem Kondensatordielektrikum 14 versehen. Als Kondensatordielektrikum 14 ist z. B. SiO₂ in einer Dicke von 5 nm, eine Dreifachschicht aus SiO₂, Si₃N₄ und SiO₂ mit einer Dicke von jeweils etwa 2 nm geeignet. Um höhere Kapazitäten zu erzielen, ist es zweckmäßig, das Kondensatordielektrikum 14 aus einem Material mit einer relativen Dielektrizitätskonstante εᵣ > 50 zu bilden. Dafür kommen folgende Materialien in Frage:
TiO₂, BaₓSr₁₋ₓ TiO₃.

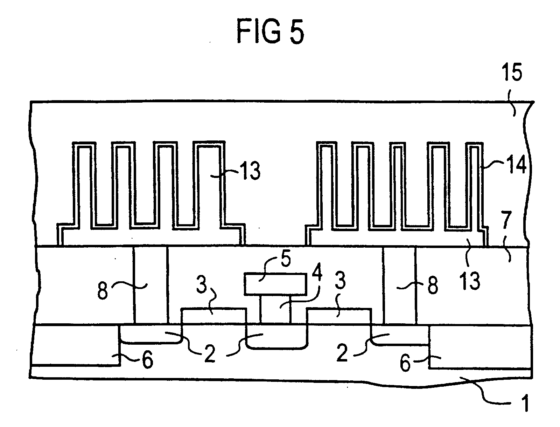

Anschließend wird ganzflächig eine leitfähige Schicht, z. B. aus dotiertem Polysilizium abgeschieden, die eine Kondensatorplatte 15 bildet (s. Figur 5). Die Kondensatorplatte 15 wird z. B. aus dotiertem Polysilizium durch in situ dotierte Abscheidung gebildet. Dabei werden die Zwischenräume zwischen benachbarten Säulenstrukturen 91 vollständig aufgefüllt. Die Kondensatorplatte 15 wird z. B. n-dotiert mit einer Dotierstoffkonzentration von 10²¹/cm³.

Das Verfahren ist nicht auf das hier gewählte Beispiel des Substrats beschränkt. Für die Durchführung des Verfahrens sind alle Substrate geeignet, in deren Oberfläche Säulenstrukturen geätzt werden können.

## Patentansprüche

1. Verfahren zur Herstellung eines Kondensators in einer Halbleiteranordnung,
- bei dem auf einem Substrat (S) eine statistische Maske (M) mit statistisch verteilten Maskenstrukturen (11) gebildet wird,
- bei dem zur Bildung der statistischen Maske (M) Keime aus Silizium und Germanium gebildet werden,
- bei dem die Keimbildung unterbrochen wird, sobald eine vorgegebene Dichte der Keime erreicht ist,
- bei dem durch selektive Epitaxie von Silizium und/oder Germanium die Größe der Keime eingestellt wird,
- bei dem unter Verwendung der statistischen Maske (M) Säulenstrukturen (91) gebildet werden, die am Säulenboden über ein Verbindungselement (92) miteinander verbunden sind,
- bei dem mindestens die Oberfläche der Säulenstrukturen (91) und des Verbindungselementes (92) elektrisch leitend sind,
- bei dem zur Bildung eines Kondensatordielektrikums (14) eine dielektrische Schicht mit im wesentlichen konformer Kantenbedeckung erzeugt wird, die mindestens die Oberfläche der Säulenstrukturen (91) bedeckt,
- bei dem zur Bildung einer Kondensatorplatte (15) eine leitfähige Schicht mit im wesentlichen konformer Kantenbedekkung abgeschieden wird.

2. Verfahren nach Anspruch 1,
bei dem die statistische Maske (M) mit Strukturgrößen im Bereich zwischen 1 nm und 100 nm gebildet wird.

3. Verfahren nach Anspruch 1 oder 2,
bei dem die Keime zur CVD-Abscheidung unter Verwendung eines Prozeßgases, das mindestens eine der Verbindungen SiH₄, GeH₄, N₂, Ar, He und H₂ enthält, gebildet werden.

4. Verfahren nach einem der Ansprüche 1 bis 3,
bei dem das Substrat (S) eine Maskenschicht (10) umfaßt, die unter Verwendung der statistischen Maske (M) als Ätzmaske strukturiert wird und die gemeinsam mit der statistischen Maske (M) bei der Bildung der Säulenstrukturen (91) als Ätzmaske eingesetzt wird.

5. Verfahren nach einem der Ansprüche 1 bis 4,
- bei dem die Säulenstrukturen (91) und das Verbindungselement (92) aus dotiertem Silizium gebildet werden,
- bei dem das Kondensatordielektrikum (14) aus SiO₂ und/oder Si₃N₄ oder aus einem dielektrischen Material mit einer relativen Dielektrizitätskonstante εᵣ > 50 gebildet wird,
- bei dem die Kondensatorplatte (15) aus dotiertem Polysilizium gebildet wird.

## Claims

1. Process for manufacturing a capacitor in a semiconductor arrangement,
- in which a statistical mask (M) having statistically distributed mask structures (11) is formed on a substrate (S),
- in which, in order to form the statistical mask (M), nuclei of silicon and germanium are formed,
- in which the nucleation is interrupted as soon as a predetermined density of the nuclei is reached,
- in which the size of the nuclei is set by selective epitaxy of silicon and/or germanium,
- in which pillar structures (91) are formed using the statistical mask (M), the said structures being connected to one another at the pillar base via a connection element (2),
- in which at least the surface of the pillar structures (91) and of the connection element (92) are electrically conductive,
- in which, in order to form a capacitor dielectric (14), a dielectric layer with essentially conformal edge coverage is produced, which covers at least the surface of the pillar structures (91),
- in which, in order to form a capacitor plate (15), a conductive layer with essentially conformal edge coverage is deposited.

2. Process according to Claim 1, in which the statistical mask (M) is formed with structure sizes in the range between 1 nm and 100 nm.

3. Process according to Claim 1 or 2, in which the nuclei are formed for CVD deposition using a process gas containing at least one of the compounds SiH₄, GeH₄, N₂, Ar, He and H₂.

4. Process according to one of Claims 1 to 3, in which the substrate (S) comprises a mask layer (10) which is patterned using the statistical mask (M) as etching mask and which is used as etching mask together with the statistical mask (M) during the formation of the pillar structures (91).

5. Process according to one of Claims 1 to 4,
- in which the pillar structures (91) and the connection element (92) are formed from doped silicon,
- in which the capacitor dielectric (14) is formed from SiO₂ and/or Si₃N₄ or from a dielectric material having a relative permittivity εᵣ > 50,
- in which the capacitor plate (15) is formed from doped polysilicon.

## Revendications

1. Procédé de fabrication d'un condensateur dans un dispositif à semi-conducteur,
- dans lequel on forme sur un substrat (S) un masque (M) statistique comportant des structures (11) de masque réparties statistiquement,
- dans lequel on forme en vue de la formation du masque (M) statistique des germes en silicium et en germanium,
- dans lequel on interrompt la formation de germes dès qu'une densité prescrite des germes est atteinte,
- dans lequel on règle par épitaxie sélective de silicium et/ou de germanium la dimension des germes,
- dans lequel on forme en utilisant le masque (M) statistique des structures (91) en colonnes qui sont reliées entre elles au fond des colonnes par l'intermédiaire d'un élément (92) de liaison,
- dans lequel au moins la surface des structures (91) en colonnes et de l'élément (92) de liaison sont conductrices de l'électricité,
- dans lequel on produit en vue de la formation d'un diélectrique (14) de condensateur une couche diélectrique à recouvrement de bords sensiblement conforme, qui recouvre au moins la surfaces des structures (91) en colonnes,
- dans lequel on dépose en vue de la formation d'une plaque (15) de condensateur une couche conductrice à recouvrement de bords sensiblement conforme.

2. Procédé suivant la revendication 1, dans lequel on forme le masque (M) statistique en ayant des dimensions de structure dans l'intervalle entre 1 nm et 100 nm.

3. Procédé suivant la revendication 1 ou 2, dans lequel on forme les germes en vue du dépôt chimique en phase vapeur en utilisant un gaz opératoire qui contient au moins l'un des composés SiH₄, GeH₄, N₂, Ar, He et H₂.

4. Procédé suivant l'une des revendications 1 à 3, dans lequel le substrat (S) comprend une couche (10) de masque qui est structurée comme masque d'attaque chimique en utilisant le masque (M) statistique et qui est introduite conjointement avec le masque (M) statistique lors de la formation des structures (91) en colonnes comme masque d'attaque chimique.

5. Procédé suivant l'une des revendications 1 à 4,
- dans lequel on forme les structures (91) en colonnes et l'élément (92) de liaison en silicium dopé,
- dans lequel on forme le diélectrique (14) de condensateur en SiO₂ et/ou en Si₃N₄ ou en un matériau diélectrique ayant une constante diélectrique relative εᵣ > 50,
- dans lequel on forme la plaque (15) de condensateur en polysilicium dopé.
